(19)

**Europäisches Patentamt**

**European Patent Office**

**Office européen des brevets**

(11) **EP 4 707 423 A1**

(12) **EUROPEAN PATENT APPLICATION**

(43) Date of publication:
**11.03.2026 Bulletin 2026/11**

(21) Application number: **24198886.4**

(22) Date of filing: **06.09.2024**

(51) International Patent Classification (IPC):
***C23C 14/02*** (2006.01)   ***B23B 27/14*** (2006.01)
***C23C 14/06*** (2006.01)   ***C23C 28/04*** (2006.01)

(52) Cooperative Patent Classification (CPC):
**C23C 14/067; B23B 27/14; C23C 14/024;
C23C 28/044**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **VOESTALPINE EIFELER VACOTEC GMBH
40549 Düsseldorf (DE)**
• **RWTH Aachen
52062 Aachen (DE)**

(72) Inventors:
• **EVERTZ, Simon
40668 Meerbusch (DE)**

• **GLATZ, Stefan Albert
40589 Düsseldorf (DE)**
• **SCHNEIDER, Jochen Michael
52066 Aachen (DE)**
• **SALMAN, Sameer
52074 Aachen (DE)**
• **NAYAK, Ganesh Kumar
52074 Aachen (DE)**
• **NAVIDI KASHANI, Amir Hossein
52074 Aachen (DE)**

(74) Representative: **Lambsdorff & Lange
Patentanwälte
Partnerschaft mbB
Grillparzerstraße 12A
81675 München (DE)**

(54) **WORKPIECE HAVING A METAL BORIDE HARD MATERIAL LAYER**

(57)    A workpiece includes a substrate and a hard material layer disposed over the substrate. The hard material layer comprises a metal boride layer having a composition $((Ti_xAl_{1-x})_{1-y}Si_y)B_{2+z}$ with

$$0.3 \leq x \leq 0.6, \ 0 < y \leq 0.2,$$

and

$$-0.3 \leq z \leq 0.3.$$

EP 4 707 423 A1

Fig. 1

## Description

### Technical Field

This disclosure relates to a workpiece having a hard material layer formed over a substrate, and in particular to a workpiece used as a tool for machining or forming operations.

### Background

The use of protective coatings on tools for machining or forming materials of high hardness, in particular for cutting and milling metal materials of high hardness, is known. Such tools include a substrate and a hard material layer to protect the substrate, to extend the lifetime of the tool and to improve its operational performance.

Since many years, efforts have been made to improve the workpiece (e.g., tool) performance, for example, wear resistance. Common hard material layers are metal nitride coatings such as TiN coatings and (Al,Ti)N-based coatings, which combine attractive mechanical properties such as high hardness and improved temperature and oxidation resistance.

Further, protective coatings based on metal borides have been described. $TiB_2$ is known to exhibit a higher hardness than metal nitride coatings also at high temperatures. However, $TiB_2$ suffers from oxidation since boron (B) has a strong tendency to chemically combine with oxygen.

Alloying $TiB_2$ with aluminum (Al) provides a $(Ti,Al)B_2$ system which exhibits improved oxidation resistance at high temperatures, however, at the expense of its mechanical properties.

Many applications, such as milling Inconel or Ti, require high mechanical properties, as high cutting forces occur. Further, high temperatures (>1000°C), thermal shock and oxidation may occur in dry milling in oxidative atmosphere.

A workpiece considered herein is subjected to thermal load, mechanical load, and chemical interaction. In addition to high thermal stability, several other properties of the hard material layer may be important in practice. The tool should have high oxidation resistance and high hardness up to at least 1000°C. In many applications, the material of the hard material layer (coating) should have a low thermal conductivity in order to allow higher machining speeds and longer tool lifetime (i.e., to keep the thermal load away from the substrate of the tool or, in other words, to protect the substrate). Further aspects which may be of importance for the hard material layer are phase stability, a high fracture toughness, a high abrasion resistance, a low surface roughness, low intrinsic stress and a low adhesion to the metal to be machined. Further, the hard material layer (coating) should have excellent adhesion to the substrate in order to avoid chipping.

### Summary

According to an aspect of the disclosure a workpiece comprises a substrate and a hard material layer disposed over the substrate. The hard material layer comprises a metal boride layer having a composition $((Ti_xAl_{1-x})_{1-y}Si_y)B_{2+z}$ with $0.3 \leq x \leq 0.6$,

$$0 < y \leq 0.2,$$

and

$$-0.3 \leq z \leq 0.3.$$

According to another aspect of the disclosure, a method of manufacturing a workpiece comprising a substrate and a hard material layer disposed over the substrate as described above uses physical vapor deposition to generate the hard material layer over the substrate.

### Brief description of the drawings

The elements of the drawings are not necessarily to scale relative to each other. Like reference numerals designate corresponding similar parts. The features of the various illustrated examples can be combined unless they exclude each other and/or can be selectively omitted if not described to be necessarily required. Examples are depicted in the drawings and are exemplarily detailed in the description which follows.

Figure 1 is a perspective view of an exemplary tool used for hard metal cutting or milling.

Figure 2 is a diagram showing computational results of the formation energy $\Delta E_f$ in units of meV per atom for Al concentrations of 1-x = 0.4 and 1-x = 0.6 as a function of the Si content (upper axis: Si concentration in at.%; lower axis: Si fraction on metal sites in y).

Figure 3 is a diagram showing computational results of the Young's modulus in units of GPa as a function of the Si content in y.

Figure 4A shows two diagrams for a Si content of y = 0.1. The left-side graph is a diagram showing computational results of the vacancy formation energy $E_{f,vac}$ in units of eV per atom for Al, Ti, Si, B, and the right-side graph is a diagram showing computational results of the diffusion migration barrier $E_b$ in units of eV per atom for Al, Ti, Si.

Figure 4B shows the same two diagrams as Figure 4A for a higher Si content of y = 0.5.

Figure 5 illustrates the hP1 lattice structure of $(TiAl)SiB_2$.

Figure 6 illustrates X-ray diffraction (XRD) diagrams of an example of a hard material layer composition.

Figure 7 is a diagram illustrating the growth of an oxide layer on the surface of the hard material layer over the oxidation time in hours.

Figure 8 is a STEM (scanning electron microscope) sectional image of an example of a hard material layer and an EDX (energy-dispersive X-ray spectroscopy) graph illustrating measurement results of the chemical composition of the exemplary hard material layer.

Figures 9A to 9C illustrate examples of a hard material layer on a substrate of a workpiece (e.g., tool).

**Detailed description**

The words "over" or "on" or "beneath" with regard to a part, element or material layer formed or located or disposed or arranged or placed "over" or "on" or "beneath" a surface may be used herein to mean that the part, element, or material layer be located (e.g. placed, formed, arranged, disposed, etc.) "directly on" or "directly under", e.g. in direct contact with, the implied surface. The word "over" or "on" or "beneath" used with regard to a part, element, or material layer formed or located or disposed or arranged or placed "over" or "on" or "beneath" a surface may, however, either be used herein to mean that the part, element or material layer be located (e.g. placed, formed, arranged, deposited, etc.) "indirectly on" or "indirectly under" the implied surface, with one or more additional parts, elements or material layers being arranged between the implied surface and the part, element or material layer.

Without loss of generality, the workpiece according to the disclosure is exemplified herein as a tool. In general, however, it is also possible to use the hard material layer described herein on a substrate to produce workpieces other than tools.

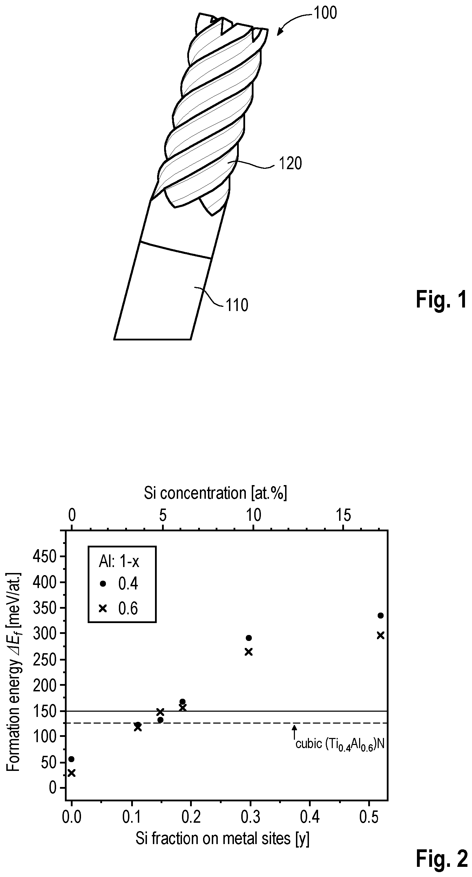

Figure 1 illustrates an exemplary tool or workpiece 100 used for metal cutting or milling operations. In the example shown, the workpiece 100 is an end mill. However, other tools such as, e.g., shaft cutters, etc., for machining hard materials may be examples for workpieces 100 disclosed herein.

In particular, workpieces 100 described herein may be designed as tools to be used in metal machining or metal cutting/milling applications, in which high temperatures greater than 900°C or 1000°C may be created and/or are present. Hard metals to be cut/milled by the tools described herein may include steel, e.g., of a hardness equal to or greater than 55 HRC (Rockwell C Hardness), titanium, nickel-based alloys such as, e.g., Inconel, etc.

The workpiece 100 includes a substrate 110 and a hard material layer 120 disposed over the substrate 110. For example, the substrate 110 may be made of metal, in particular steel, e.g. HSS, cemented carbide (CC), or MC90. The substrate 110 needs to be protected during operation. The hard material layer 120 is used as a coating to protect the substrate 110 and thereby to extend the lifetime of the workpiece 100 (e.g., tool) as well as to improve its performance.

During operation, the workpiece 100 (tool) may suffer wear and/or damage such as, e.g., cutting edge rounding, flank wear, chipping, and cratering, that can occur over time during operation of the workpiece 100. In particular, the workpiece 100 (tool) is exposed to high temperatures (approx. 1000°C), thermal shocks (i.e. sudden temperature changes when the tool teeth enter and exit the material cut or milled by the tool) and oxidation, which occurs in oxidative atmospheres, e.g. during dry milling under ambient air.

To avoid such damages or for other reasons, several aspects related to the hard material layer 120 may be important:

Main properties of interest of the metal boride based hard material layer 120 considered herein are the oxidation resistance at high temperature (e.g., > 1000°C) and the hardness at high temperature (i.e., a high hot hardness). Both quantities should be as high as possible. In addition, a reduction in thermal conductivity ($\kappa$) may be particularly desirable because the lower the thermal conductivity, the better the protection of the substrate 110 from thermal damage.

Further, for the hard material layer 120, a high thermal stability (e.g., > 1000°C), a high abrasion resistance, reduced intrinsic stress, excellent adhesion of the hard material layer 120 to the substrate 100, low surface roughness, low defect concentration in the hard material layer 120 and high chemical stability during operation may be desirable.

These and other properties are strongly dependent on the chemical and physical parameters of the hard material layer, especially on its composition and on its architecture in terms of a multi-layer structure.

One object of the invention may, e.g., be to provide a hard material layer with increased lifetime compared to existing nitride coatings by improving oxidation resistance and/or thermal stability.

Another object of the invention may, e.g., be to provide a hard material layer that dissipates the generated heat in the hard material layer (i.e., in a lateral direction) rather than in the substrate (i.e., in a direction normal to the layer).

Still another object of the invention may, e.g., be to provide a hard material layer that reduces the wear of the workpiece (e.g., tool).

According to an aspect of the disclosure, the hard material layer 120 comprises a metal boride layer having a composition $((Ti_xAl_{x-x})_{1-y}Si_y)B_{2+z}$ with $0.3 \leq x \leq 0.6$, $0 < y \leq 0.2$, and $-0.3 \leq z \leq 0.3$.

$((Ti_xAl_{1-x})_{1-y}Si_y)$ is the so-called metal sub-lattice of the metal boride composition. Here and in the following, a notation is used in which the indices x, 1-x, y, 1-y of an element or elements placed in parentheses refer to the fraction on metal lattice sites of the respective element or the elements placed in parenthesis.

To reduce the length of notation, the indices of the elements may be excluded from the notation. Further, the outer parenthesis may be omitted and the index z of deviation from stoichiometry may be suppressed. Thus, $((Ti_xAl_{1-x})_{1-y}Si_y)B_{2+z}$ may be written as $(TiAl)SiB_2$ in short. Another notation of the metal boride composition disclosed herein is Ti-Al-Si boride, always within the compositional limits given above.

Boron (B) is known to form strong covalent bonding with Ti in $TiB_2$ (titanium diboride). In $TiB_2$, boron atoms are arranged in a hexagonal structure interleaved by Ti layers, leading to the formation of strong covalent bonding (Ti-B and B-B) with metallic contributions (Ti-Ti). Hence, $TiB_2$ coatings exhibit high thermal stability, high hardness, and a very low wear rate (about a factor of 10 smaller than TiN and nearly as small as diamond). Therefore, $TiB_2$ coatings are applied as coatings for wear and corrosion protection.

However, the oxidation resistance of $TiB_2$ is lower than in metal nitrides. The thermal conductivity of $TiB_2$ is comparatively high since it is promoted by the metallic Ti-Ti bonds. Further, it has been found that it is challenging to deposit stoichiometric $TiB_2$ coatings.

Alloying $TiB_2$ by Al is known to improve the oxidation resistance. However, the mechanical properties are impaired by the addition of Al, leading to a decrease in hardness and elastic modulus.

According to this disclosure, the Ti-Al metal sub-lattice is alloyed with Si. The Ti-Al-Si metal sub-lattice of borides provides increased oxidation resistance at high temperatures.

More specifically, as described in more detail below, a Si-rich layer is formed on an oxide surface of the metal boride layer by diffusion of Si to the surface. This Si-rich oxide layer acts as a protective and/or passivating scale which prevents oxygen from further entering the metal boride layer, thereby significantly improving the oxidation resistance of the hard material layer. In effect, the oxidation resistance at high temperatures of the metal boride layer disclosed herein is better by one order of magnitude compared to TiAlN.

Moreover, the Si alloying of the Ti-Al metal sub-lattice reduces the thermal conductivity of the metal boride layer and thus of the hard material layer, thereby improving the protective effect of the hard material layer 120.

Irrespective of the composition of the metal sub-lattice, the compositions of the metal boride layer may be (approximately) stoichiometric, i.e. about 66.67 at.% (ideally, exactly 66.67 at.%) of the atoms of the total lattice is the non-metal sub-lattice of B and the rest (33.33 at.%) is the metal sub-lattice of Al-Ti-Si. However, as compositions may slightly deviate from stoichiometry, the content of B may be, e.g., in a range of 63.0 at.% to 70.0 at.% ($z = \pm 0.3$), in particular 64.2 at.% to 68.8 at.% ($z = \pm 0.2$), more in particular 65.5 at.% to 67.7 at.% ($z = \pm 0.1$) of the total lattice. If $z < -0.3$, the mechanical properties of the metal boride layer deteriorate too much. If $z > 0.3$, the oxidation tendency of the metal boride layer becomes too strong.

The effects of the elements Ti, Al, Si of the metal sub-lattice in relation to their content are described below.

Thermodynamic stability

The thermodynamic stability of Ti-Al-Si boride has been investigated for two different Al contents (fractions 1-x) as a function of the Si fraction on metal sites, i.e. y. Reference is made to Figure 2.

Figure 2 is a diagram showing calculation results on the thermodynamic stability of the Ti-Al-Si boride layer in accordance with the disclosure. The formation energy $\Delta E_f$ describes whether a material is thermodynamically stable ($\Delta E_f < 0$) or meta-stable ($\Delta E_f > 0$), such as TiAlN. From literature on TiAlN it is know that materials with $\Delta E_f < 150$ meV per atom can be synthesized as a coating by PVD.

Figure 2 illustrates that Ti-Al-Si borides having a Si fraction on metal sites y of about 0.2 maximum can be synthesized as a single phase. Further, Figure 2 illustrates that the difference in energy of formation $\Delta E_f$ for the Al fractions 1-x = 0.4 and 1-x = 0.6 are minute.

For higher Si contents (y > 0.2), Si segregation is expected. This means that other Si-rich phases may occur. Although Si segregation may be beneficial for further improving the oxidation resistance due to the formation of a silicon oxide scale at the surface of the coating, it is expected that such further Si-rich phases may impair other properties of the metal boride layer. Therefore, in order to maintain single phase Ti-Al-Si boride, $y \leq 0.2$.

Mechanical properties

The mechanical properties of Ti-Al-Si boride have been investigated as a function of the Si fraction on metal sites y. Again, calculations have been done for different Al contents.

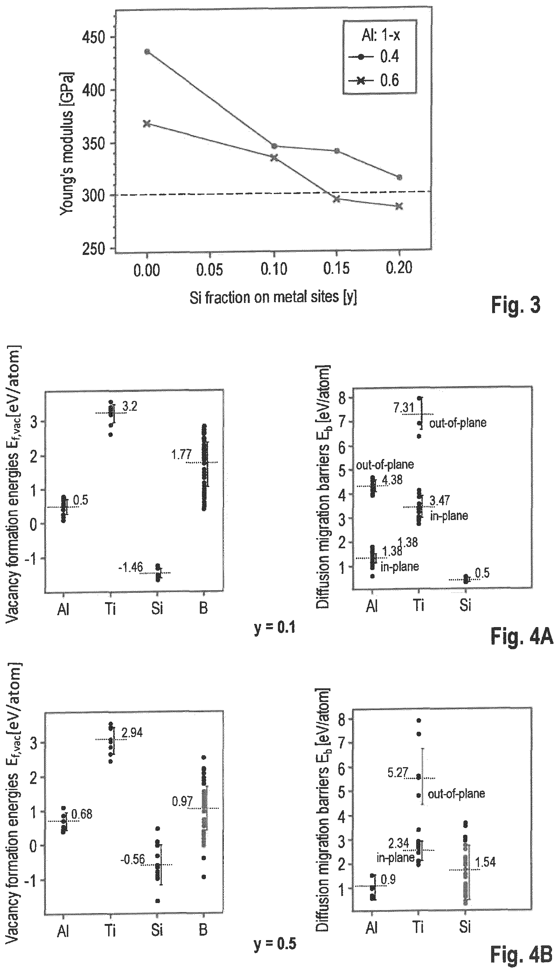

Figure 3 illustrates computational results of the Young's modulus in units of GPa as a function of the Si fraction on metal sites y. According to Figure 2, at most 1/5 of the metal sites in the metal sub-lattice Ti-Al-Si may be occupied by Si atoms.

Figure 3 illustrates that Young's modulus is reduced by the addition of Si. The reduction is approximately 16.3 GPa per at.% of Si. Further, Figure 3 shows that the Young's modulus depends on the ratio of Al atoms to (Al+Ti) atoms expressed by the Al fraction 1-x. For x = 0.6 (i.e. the maximum Ti fraction), the Young's modulus is greater than for x = 0.4 (i.e. a lower Ti fraction).

That is, the reduction of the Young's modulus by addition of Si is similar to the effect of Al-alloying. However, even for the maximum Si fraction at y = 0.2, the Young's modulus may remain larger than 300 GPa (at least if the Al fraction is not maximum).

Further, the hardness of Ti-Al-Si boride in accordance with the description has been (calculatory) estimated. The estimations revealed that the hardness is equal to or larger than 20 GPa for $y \leq 0.15$ (exemplary for Al fraction 1-x = 0.4). The effect of Si-alloying on the hardness is similar to the effect of Al-alloying.

Diffusion

As mentioned above, it has been found that Si-alloying improves the oxidation resistance of the Ti-Al-Si boride. The improvement of the oxidation resistance is caused by Si-diffusion. Si-diffusion has been investigated, and computational results are shown in Figures 4A and 4B.

The diagrams in Figure 4A relate to a Si fraction of y = 0.1 and x = 0.6. The left-side graph illustrates the dependency of the vacancy formation energy $E_{f,vac}$ in units of eV per atom. The vacancy formation energy $E_{f,vac}$ is the amount of energy needed to remove one atom from its site in the lattice in order to create space for another atom to move into the vacancy.

The graph illustrates that Si has the lowest vacancy formation energy $E_{f,vac}$ among Al, Ti, Si and B. In particular, a mean value of the vacancy formation energy $E_{f,vac}^{mean}$ = -1.46 eV/atom is considerably smaller than for Al, which has a mean value of the vacancy formation energy $E_{f,vac}^{mean}$ = 0.5 eV/atom. This means that Si is the element which is the easiest to release from a lattice site.

The right-side graph illustrates the diffusion migration barrier in units of eV per atom. The diffusion migration barrier is the energy needed for an atom in order to move from a specific position in the lattice to a different specific position. The graph illustrates that the diffusion migration barriers are lowest for Si, followed by Al for in-plane movement, Ti for in-plane movement, Al for out-of-plane movement and Ti for out-of-plane movement. More specifically, the mean value of the diffusion migration barrier $E_b^{mean}$ for Si is 0.5 eV/atom, while the mean values of $E_b^{mean}$ for Al and Ti for in-plane movement and out-of-plane movement are all higher. Figuratively speaking, Si is the "first mover" when energy is introduced into the lattice.

In other words, the graphs of Figure 4A show that Si is the atom that can most easily be released from its lattice site and the atom that can most easily move through the lattice. As a consequence, Si diffusion is much more prominent in Ti-Al-Si boride than Al diffusion. This leads to an enrichment of Si at the surface of the Ti-Al-Si boride layer and to the formation of a Si-rich oxide layer (oxide scale) on the surface. This Si-rich oxide layer (oxide scale) acts as an effective oxide barrier, especially at high temperatures.

Hence, Si-alloying allows to generate a thin, high-density oxide layer on the metal boride layer which protects the titanium boride component of the Ti-Al-Si boride system against oxidation.

In both graphs of Figure 4A, a plurality of data points per element are depicted. The plurality of data points corresponds to the variety of different lattice sites on which the respective atom may be located in the lattice (for the left-side graph) or on the variety of different paths (in terms of different neighboring atoms at the start position, the destination position as well as on the different directions) the respective atom is moving through the lattice (for the right-side graph).

Thus, both graphs illustrate distributions of the respective energies, the mean values and standard deviations thereof. The plurality of data points per element are also referred to as "energy envelopes" in literature.

Figure 4B shows the same two diagrams as Figure 4A, however for a Si content of y = 0.5, which is too high. Again, x = 0.6 was used. Such Ti-Al-Si boride system is not part of the invention. As shown in the left-side graph, Si remains the element which is easiest to be removed from its lattice site. However, as shown in the right-side graph, Si movement is made more difficult (the mean diffusion migration barrier $E_f^{mean}$ is raised from 0.5 eV/atom to 1.54 eV/atom). Hence, Si diffusion is no longer favored over Al diffusion.

It is to be noted that in AlTiN the vacancy formation energies $E_{f,vac}$ as well as the diffusion migration barriers $E_b$ are always considerably higher than in $(TiAl)SiB_2$. In Table 1 the mean values $E_{f,vac}^{mean}$ and $E_b^{mean}$ of these quantities are summarized.

Table 1: Mean vacancy formation energy $E_{f,vac}^{mean}$ and mean diffusion migrationbarrier $E_b^{mean}$

| Element | Element $E_{f,vac}^{mean}$ [eV/atom] | | $E_b^{mean}$ [eV/atom] | |
|---|---|---|---|---|
| | $(TiAl)SiB_2$ | AlTiN | $(TiAl)SiB_2$ | AlTiNAl |
| Al | 0.5 | 1.88 | 1.38-4.38 | 2.37 |
| Ti | 3.2 | 2.94 | 3.47-7.31 | 3.94 |
| Si | -1.46 | | 0.5 | |
| B | 1.77 | | | |
| N | | 3.49 | | 4.02 |

Table 1 shows that both the mean vacancy formation energy $E_{f,vac}^{mean}$ and the mean diffusion migration barrier $E_b^{mean}$ are lowest for Si in $(TiAl)SiB_2$ and are significantly lower than those energies for any of the elements of the well-known coating material AlTiN. Further, Table 1 again shows that Si is the "first mover", i.e. upon heating it will diffuse out of the material first to form a protective oxide layer (oxide scale) at the surface of the $(TiAl)SiB_2$ coating.

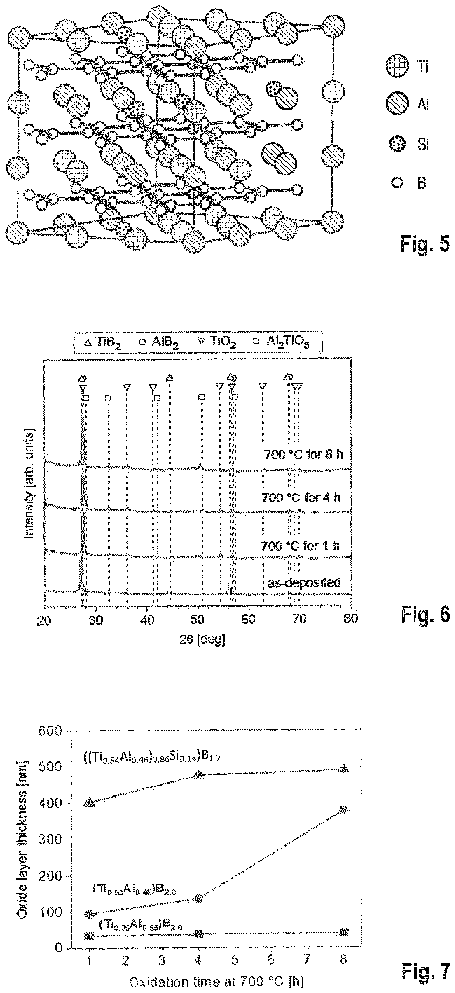

Figure 5 shows that $(TiAl)SiB_2$ crystallizes in an atomically layered hexagonal hP1 structure. In Figure 5 an ideally stoichiometric metal boride composition is shown. The exemplary composition of the lattice shown in Figure 5 is $((Ti_{0.4}Al_{0.6})_{0.9}Si_{0.1})B_2$.

Table 2 summarizes exemplary chemical compositions and preferred boundaries of the metal sub-lattice of the metal boride layer according to the disclosure (upper and lower limits, preferred upper and lower limits, specifically preferred upper and lower limits).

Table 2: Boundaries of x and y and exemplary chemical compositions of the metal boride layer $((Ti_xAl_{1-x})_{1-y}Si_y)B_{2+z}$

| | x | y | z |
|---|---|---|---|
| Upper limit | 0.60 | 0.20 | 0.3 |
| Pref. upper limit | 0.55 | 0.19 | 0.2 |
| Spec. pref. upper limit | 0.50 | 0.17 | 0.1 |
| Spec. pref. lower limit | 0.35 | 0.10 | -0.1 |
| Pref. lower limit | 0.31 | 0.05 | -0.2 |
| Lower limit | 0.30 | >0 | -0.3 |

As mentioned above, it is possible to form borides stoichiometric (66.67 at.% B of the total lattice), over-stoichiometric (more than 66.67 at.% B of the total lattice) or under-stoichiometric (less than 66.67 at.% B of the total lattice). Both latter scenarios (over-stoichiometric and under-stoichiometric borides) may decrease the mechanical properties and may decrease the phase stability, as additional vacancies (metal vacancies if boron is over-stoichiometric, and boron vacancies if boron is under-stoichiometric) form.

Hence, preferentially a stoichiometric metal boride composition (z = 0) may be targeted as this offers the highest mechanical properties.

Figure 6 illustrates X-ray diffraction (XRD) diagrams of an example of a hard material layer composition. The exemplary composition was $((Ti_{0.54}Al_{0.46})_{0.86}Si_{0.14})B_{1.7}$.

Peaks in the intensity relate to different phases. As deposited, single-phase Ti-Al-Si boride (i.e., the $(TiAl)SiB_2$

phase) formed as predicted (the (TiAl)SiB$_2$ phase occurs in the TiB$_2$ or AlB$_2$ structure and can therefore be identified by the TiB$_2$ and/or AlB$_2$ peaks, since no XRD reference data is available for the (TiAl)SiB$_2$ phase). To study the oxidation behavior, the single-phase Ti-Al-Si boride as deposited was subjected to a heat treatment at 700°C for 1 hour, 4 hours and 8 hours.

Figure 6 illustrates that the (TiAl)SiB$_2$ phase is still present after the heat treatment. That is, the (TiAl)SiB$_2$ phase does not vanish and is not completely oxidized.

Figure 7 illustrates measurement data reflecting the growth of an oxide layer at the surface of the Ti-Al-Si boride hard material layer for the exemplary composition $((Ti_{0.54}Al_{0.46})_{0.86}Si_{0.14})B_{1.7}$. The thickness of the oxide layer is depicted in units of nm. The layer thickness was determined after 1, 4 and 8 hours oxidation time at an oxidation temperature of 700 °C under atmosphere. Comparative measurement data is depicted in Figure 7 for $(Ti_{0.54}Al_{0.46})B_{2.0}$ and $(Ti_{0.35}Al_{0.05})B_{2.0}$.

A thin oxide layer is formed on $(Ti_{0.35}Al_{0.65})B_{2.0}$, which does not grow over time. This layer is Al-rich and has poor mechanical properties.

Comparing the Si-free composition $(Ti_{0.54}Al_{0.46})B_{2.0}$ and the Si-alloyed composition $((Ti_{0.54}Al_{0.46})_{0.86}Si_{0.14})B_{1.7}$ according to the disclosure, the following features are observed:

(1) The oxide layer thickness of the Si-alloyed composition is larger than the oxide layer thickness of the Si-free composition (for an oxidation time equal to or less than 8 h at 700°C).

(2) The initial oxide layer growth of the Si-alloyed composition is much larger than the initial oxide layer growth of the Si-free composition.

(3) The oxide layer growth of the Si-alloyed composition is self-limiting, while the oxide layer growth of the Si-free composition appears to become stronger over time.

Feature (3) indicates that an effective protection against oxidation is achieved for the Si-alloyed composition (even for non-stoichiometric compositions). Features (2) and (3) indicate that the quality of the oxide layer grown on the Si-alloyed composition is significantly better in terms of oxidation resistance than the quality of the oxide layer grown on the Si-free composition, as the oxide layer on the Si-alloyed composition appears to prevent further oxygen ingress, while the oxide layer on the Si-free composition appears to continue to grow on the underside of the oxide layer.

In other words, the oxide layer on a Ti-Al-Si boride composition according to the disclosure is initially thicker than for the Si-free Ti-Al boride, but is stabilized with time, while the oxide growth rate increases for Ti-Al boride with increasing oxidation time. This different behavior is due to the formation of a Si-rich top (high-density) oxide layer at the oxide surface of the Ti-Al-Si boride.

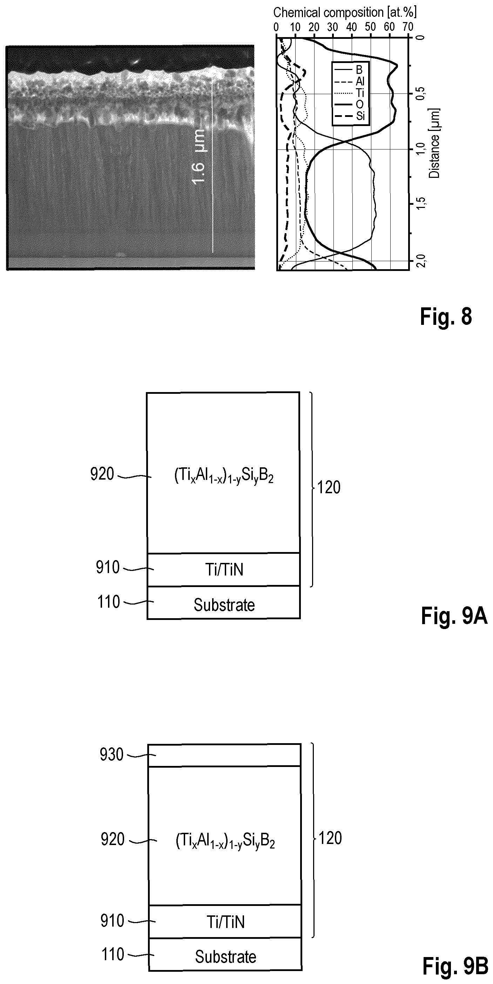

Figure 8 illustrates results obtained by STEM-EDX analysis on the oxide layer of the exemplary composition $((Ti_{0.54}Al_{0.46})_{0.86}Si_{0.14})B_{1.7}$ of Figures 6 and 7 after oxidation at 700°C for 8 hours. A Si-rich top layer forms at the oxide layer surface. This indicates that Si may have a strong influence on surface properties of the oxide layer.

Generally, the thickness of the oxide layer may be about 300 nm to 600 nm, for example. The thickness of the Si-rich layer at the top of the oxide layer may, e.g., be about 50 nm to 250 nm.

Compared with conventional nitride layers, the oxide layer thickness is smaller than that of commercial nitride layers. Further, as mentioned above, a dense Si(-rich) oxide layer grows, which rapidly loses growth speed with increasing layer thickness and thus only grows very slowly (to barely noticeable). This is in contrast to the oxide layer growth on Ti nitride, for example, where such oxidation behavior is generally not observed.

Figures 9A to 9C illustrate various illustrative examples of hard material layers 120, which could be used for coating the substrate 110 of the workpiece 100 (see, e.g., Figure 1).

In all examples disclosed herein, the hard material layer 120 includes at least one metal boride layer 920. The metal boride layer 920 is the functional layer of the hard material layer 120.

Optionally, an adhesion layer 910 may be disposed between the substrate 110 and the metal boride layer 920. The adhesion layer 910 may, for example, comprise or be of Ti and/or TiN. The adhesion layer 910 provides high adhesion of the metal boride layer 920 to the substrate 110.

Referring to Figure 9A, the metal boride layer 920 may be a mono-layer, i.e. may be a single homogenous layer.

Referring to Figure 9B, the hard material layer 120 may be provided with an optional decorative top coating 930. The decorative top coating 930 may comprise or consist of, for example, Ti(O,C,N). TiN, for example, results in a golden coating. With a Ti(O,N) coating, the color can be adjusted by the oxygen content. A Ti(C,N) coating has a pink color. The (optional) decorative top coating 930 may have a layer thickness in a range between, e.g., 10 nm and 1,000 nm. Preferably, the layer thickness may be, e.g., about 100 nm.

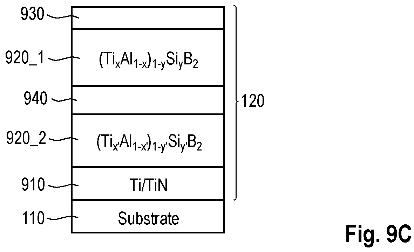

Figure 9C schematically illustrates a multi-layer approach, which may improve the lifetime of the workpiece 100 compared to the mono-layer implementation as shown in Figures 9A and 9B. In the multi-layer approach, at least two metal boride layers 920_1, 920_2 are included in the hard material layer 120.

The second metal boride layer 920_2 may have a composition $((Ti_{x'}Al_{1-x'})_{1-y'}Si_{y'})B_{2+z'}$ with $0.3 \leq x' \leq 0.6$, $0 < y' \leq$

0.2, and $-0.3 \leq z' \leq 0.3$. The composition indices x', y' and z' may lie within the limits given in Table 2 for the corresponding indices x, y and z, respectively. Further, to avoid reiteration, the disclosure to the metal boride layer 920 and the first metal boride layer 920_1 is incorporated by reference to the description of the second metal boride layer 920_2.

The two metal boride layers 920_1, 920_2 may, e.g., have different compositions, i.e. $x \neq x'$ and/or $y \neq y'$. They may, e.g., be separated by an intermediate layer 940. The intermediate layer 940 may, e.g., be of Ti and/or TiN and/or any of the compositions set out for the decorative top layer 930. Further examples of the intermediate layer 940 comprise or consist of Ti, Al, Si, Cr and combinations thereof, optionally as carbo-nitride [-(C)N] layers or boride ($-B_2$) layers.

In other examples, the first and second metal boride layers 920_1, 920_2 may be of the same composition, i.e. x = x' and y = y'. In this case, the intermediate layer 940 is needed to create the multi-layer stack which is included as a functional layer in the hard material layer 120.

The intermediate layer 940 may have a heat conductivity which is less than the heat conductivity of the first metal boride layer 920_1 and the heat conductivity of the second metal boride layer 920_2. That way, the anisotropy of heat transport is increased with the effect that the protection of the substrate 110 is improved.

While in Figure 9C two metal boride layers 920_1, 920_2 (of different or identical compositions) are shown, the hard material layer 120 may include a much higher number of metal boride layers 920_1, 920_2, ..., 920_N, with N is equal to or greater than 10, 50, 100, 500, etc. The higher the number N of metal boride layers 920_1, 920_2, ..., 920_N, the higher the number of layer boundaries, which effectively enhance the anisotropy of thermal conductivity. Hence, the multi-layer approach of Figure 9C may better allow combining the desired property of low thermal conductivity with hardness (abrasion resistance).

In the multi-layer approach of Figure 9C, all of the metal boride layers 920_1, 920_2 may have each their respective composition according to any of the ranges set out herein.

The thickness of the metal boride layers 920, 920_1, 920_2 may vary over a broad range. For example, the layer thickness may, e.g., be in a range between 10 nm and 4,000 nm or 100 nm and 2,000 nm or 200 nm and 1,000 nm, for example. In the multi-layer approach, if the layer thickness of the metal boride layers 920_1, 920_2 is equal to or less than 50, 30 or 10 nm, such layers are often referred to as nano layers.

A method of manufacturing a workpiece comprising a substrate and a hard material layer disposed over the substrate as described above may use a PVD (Physical Vapor Deposition) process to generate the adhesion layer 910, the metal boride layer(s) 920, 920_1, 920_2, the intermediate layer 940 and, e.g., the top coating 930. Magnetron sputtering (e.g., direct current magnetron sputtering, radio frequency magnetron sputtering, high power impulse magnetron sputtering), or (pulsed) cathodic arc evaporation may be used, for example.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

**Claims**

1. A workpiece comprising:

   a substrate, and
   a hard material layer disposed over the substrate, wherein the hard material layer comprises a metal boride layer having a composition $((Ti_xAl_{1-x})_{1-y}Si_y)B_{2+z}$ with

$$0.3 \leq x \leq 0.6,$$

$$0 < y \leq 0.2,$$

   and

$$-0.3 \leq z \leq 0.3.$$

2. The workpiece of claim 1, wherein

$$0.31 \leq x \leq 0.55.$$

3. The workpiece of claim 1, wherein

$$0.35 \leq x \leq 0.50.$$

4. The workpiece of any of claims 1 to 3, wherein

$$0.05 \leq y \leq 0.19.$$

5. The workpiece of any of the preceding claims, wherein

$$0.10 \leq y \leq 0.17.$$

6. The workpiece of any of the preceding claims, wherein $-0.2 \leq z \leq 0.2$, in particular $-0.1 \leq z \leq 0.1$, more in particular wherein the metal boride layer is stoichiometric.

7. The workpiece of any of the preceding claims, wherein the metal boride layer has a hardness of at least 20 GPa.

8. The workpiece of any of the preceding claims, wherein the metal boride layer has a Young's modulus of equal to or greater than 300 GPa.

9. The workpiece of any of the preceding claims, wherein the hard material layer further comprises at least a further metal boride layer having a composition $((Ti_{x'},Al_{1-x'})_{1-y'}Si_{y'})B_{2+z'}$ with

$$0.3 \leq x' \leq 0.6,$$

$$0 < y' \leq 0.2,$$

and

$$-0.3 \leq z' \leq 0.3.$$

10. The workpiece of claim 9, wherein the metal boride layer is disposed over the further metal boride layer in a direction facing away from the substrate, and $y \neq y'$ and/or $x \neq x'$.

11. The workpiece of any of claim 9 or 10, wherein the hard material layer further comprises an intermediate layer arranged between the metal boride layer and the further metal boride layer, wherein the intermediate layer has a heat conductivity which is less than the heat conductivity of the metal boride layer and the heat conductivity of the further metal boride layer.

12. The workpiece of any of the preceding claims, wherein the hard material layer further comprises an adhesion layer, wherein the adhesion layer is arranged between the substrate and the lowermost metal boride layer.

13. The workpiece of claim 12, wherein the adhesion layer comprises a TiN and/or a Ti layer.

14. The workpiece of any of the preceding claims, wherein the workpiece is a coated tool, in particular a cutting machine tool.

15. A method of manufacturing a workpiece comprising a substrate and a hard material layer disposed over the substrate, wherein the hard material layer comprises a metal boride layer having a composition $((Ti_xAl_{1-x})_{1-y}Si_y)B_{2+z}$ with $0.3 \leq x \leq 0.6$, $0 < y \leq 0.2$, $-0.3 \leq z \leq 0.3$, the method comprising:
using physical vapor deposition to generate the hard material layer over the substrate.

**Fig. 1**

**Fig. 2**

Fig. 3

y = 0.1

Fig. 4A

y = 0.5

Fig. 4B

Fig. 5

Fig. 6

Fig. 7

Chemical composition [at.%]
0 10 20 30 40 50 60 70

B
Al
Ti
O
Si

Distance [µm]

1.6 µm

**Fig. 8**

920 —— $(Ti_xAl_{1-x})_{1-y}Si_yB_2$

120

910 —— Ti/TiN

110 —— Substrate

**Fig. 9A**

930 ——

920 —— $(Ti_xAl_{1-x})_{1-y}Si_yB_2$

120

910 —— Ti/TiN

110 —— Substrate

**Fig. 9B**

930 —

920_1 — $(Ti_xAl_{1-x})_{1-y}Si_yB_2$

940 —

920_2 — $(Ti_{x'}Al_{1-x'})_{1-y'}Si_{y'}B_2$

910 — Ti/TiN

110 — Substrate

120

**Fig. 9C**

| | Europäisches Patentamt European Patent Office Office européen des brevets | **EUROPEAN SEARCH REPORT** | **Application Number** EP 24 19 8886 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DONG CHUANYAO ET AL: "Inhibiting low-dimensional defects of titanium diboride coatings by Si incorporation: Toward enhanced corrosion resistance and mechanical properties", APPLIED SURFACE SCIENCE,, vol. 594, 27 April 2022 (2022-04-27), XP087062011, DOI: 10.1016/J.APSUSC.2022.153504 [retrieved on 2022-04-27] * paragraph [02.1]; table 1 * * paragraph [0004] * ----- | 1-15 | INV. C23C14/02 B23B27/14 C23C14/06 C23C28/04 |
| A | BAHR A. ET AL: "High-temperature oxidation resistance of ternary and quaternary Cr-(Mo)-Si-B2-z coatings - Influence of Mo addition", SURFACE AND COATINGS TECHNOLOGY, vol. 468, 21 June 2023 (2023-06-21), page 129733, XP093152464, NL ISSN: 0257-8972, DOI: 10.1016/j.surfcoat.2023.129733 * paragraph [0002]; table 1 * ----- | 1-15 | |
| A | MOCKUTE A ET AL: "Synthesis and characterization of (Ti1-xAlx)B2+[Delta]thin films from combinatorial magnetron sputtering", THIN SOLID FILMS, ELSEVIER, AMSTERDAM, NL, vol. 669, 26 October 2018 (2018-10-26), pages 181-187, XP085560322, ISSN: 0040-6090, DOI: 10.1016/J.TSF.2018.10.042 * paragraph [0002]; table 1 * ----- -/-- | 1-15 | TECHNICAL FIELDS SEARCHED (IPC) C23C B23G B23B |

The present search report has been drawn up for all claims

| Place of search | Date of completion of the search | Examiner |
|---|---|---|
| The Hague | 24 March 2025 | Kudelka, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | STÜBER M ET AL: "Microstructure of Al-containing magnetron sputtered TiB2 thin films", THIN SOLID FILMS, ELSEVIER, AMSTERDAM, NL, vol. 688, 10 June 2019 (2019-06-10), XP085819340, ISSN: 0040-6090, DOI: 10.1016/J.TSF.2019.06.011 [retrieved on 2019-06-10] * paragraph [0002]; table 1 * ----- | 1-15 | |

| | | | TECHNICAL FIELDS SEARCHED (IPC) |
|---|---|---|---|

The present search report has been drawn up for all claims

| Place of search | Date of completion of the search | Examiner |
|---|---|---|
| The Hague | 24 March 2025 | Kudelka, Stephan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document